# EUROPEAN PATENT SPECIFICATION

(11) **EP 2 927 963 B1**
(45) Date of publication and mention of the grant of the patent: **26.05.2021**
(21) Application number: 14163239.8
(22) Date of filing: 02.04.2014
(51) Int. Cl.: H01L 29/76, H01L 29/167, H01L 29/207, H01L 29/227

(54) **Single-charge tunnelling device**
Einzelladungstunnelvorrichtung
Dispositif à effet tunnel à charge unique

(43) Date of publication of application: 07.10.2015
(73) Proprietor: Hitachi, Ltd., Tokyo (JP)
(72) Inventor: Gonzalez Zalba, Miguel, Cambridge, Cambridgeshire CB3 0HE (GB); Ferguson, Andrew, Cambridge, Cambridgeshire CB3 0HE (GB)
(74) Representative: Piotrowicz, Pawel Jan Andrzej

(56) References cited:
- EP-A1- 2 421 043
- WO-A2-2004/021410
- GB-A- 2 295 488
- US-B1- 6 369 404
- T. LOHNER ET AL.: "Comparative investigation of damage induced by diatomic and monoatomic ion implantation in silicon", NUCLEAR INSTRUMENTS AND METHODS IN PHYSICS RESEARCH B, vol. B85, March 1994 (1994-03), pages 524-527, XP002728554, Netherlands DOI: 10.1016/0168-583X(94)95876-9

## Description

The present invention relates to a single-charge tunnelling device.

WO 2004/021410 A2 describes field-effect semiconductor devices in which small numbers of dopant atoms are arranged in a channel in an engineered array or engineered arrays.

Single-charge tunnelling devices based on Coulomb blockade, such as single-electron transistors, are known.

Coulomb blockade can occur when the energy needed to transfer one electron to an isolated conductive region (or "island") exceeds the thermal energy. This can be achieved by making the island small enough that its capacitance, C, is sufficiently low that the charging energy, *e*²/2*C* (where *e* is the electronic charge), of the island exceeds the thermal energy, *k_{B}T* (where *k_{B}* is the Boltzmann constant and *T* is temperature in Kelvin). Thus, Coulomb blockade can be observed at room temperature when an island has dimensions of no more than a few nanometres and its capacitance is of the order of a few attofarads.

A single-charge tunnelling device can be formed by placing an island or a chain of islands between a pair of leads and isolating each island using tunnel barriers. When a small bias is applied between the leads, tunnelling by charge carriers on and off the island may be inhibited due to Coulomb blockade. However, Coulomb blockade may be lifted by applying a sufficiently large bias between the leads. Alternatively, if a gate electrode is provided, it can be used to adjust the electrostatic potential of the island so that, when a small bias is applied between the leads, the potential of the island can be lowered sufficiently that charge tunnelling can occur.

Single-charge tunnelling devices can be formed from various materials. For instance, the conductive regions, such as the island, leads and gate, may comprise a metal and the tunnel barriers may comprise a dielectric material. However, metals need not be used and the conductive regions may comprise a semiconductor material, such as silicon, with tunnel barriers formed by depletion regions. These types of devices are typically formed by lithography and depositing or etching material.

Single-charge tunnelling devices, however, can employ a naturally-occurring or well-defined unit as an island, such as a single atom or a pair of atoms embedded in a semiconductor or dielectric material.

For example, US 2004/0244672 A1 describes a silicon crystal in which donor atoms are substituted for silicon atoms in the surface of the silicon crystal to form an array of electrically-active dopant atoms which are spaced apart by 100 nm or less.

B. Roche et al.: "Detection of a Large Valley-Orbit Splitting in Silicon with Two-Donor Spectroscopy", Physical Review Letters, volume 108, page 206812 (2012) describes a two-dopant transistor. The transistor takes form of a 60 nm-wide, 20 nm-thick silicon-on-insulator (SOI) nanowire channel running between source and drain regions and which is doped with phosphorus (P) to a concentration of ₁₀¹⁸ cm⁻³. First and second gates overlap opposite sides of the nanowire forming a constriction having a width of 30 nm. Two dopants lie in the nanowire between the gates

US6369404 discloses electrondevices for single electron and nuclear spin measurement.

According to a first aspect of the present invention there is provided a single-charge tunnelling device. The device comprises source and drain regions and a region of crystalline semiconductor interposed between the source and drain regions. The device comprises an island in the form of a diatomic impurity molecule comprising first and second impurity atoms disposed in the semiconductor region. Charge carriers can pass between the source and drain regions via the island. The first and second atoms have an inter-atomic distance, r, no more than 10 nm.

Reducing the inter-atomic distance to or below 10 nm can increase charge carrier confinement compared to single-charge tunnelling devices employing single atoms as an island thereby increasing the ionization energy and the charging energy of the device. This can increase minimum temperature of operation of the device.

The inter-atomic distance, r, may be no more than 5 nm, no more than 2 nm or no more than twice the lattice constant of the semiconductor.

Reducing the inter-atomic distance to or below twice the lattice constant of the semiconductor (for example, around 1.1 nm in silicon) can increase the ionization energy by up to a factor of four and the charging energy by up to a factor of two compared to single-charge tunnelling devices which employ single atoms.

The semiconductor is preferably silicon. However, the semiconductor may be graphene, germanium or a semiconductor alloy, such as III-V alloy or II-VI alloy.

The semiconductor may be bulk doped with an impurity. The bulk doping impurity and the molecular impurity are preferably of opposite impurity types. For example, the semiconductor may be lightly doped with acceptors and the impurity atoms may be donors. Thus, a donor pair and a p-type silicon substrate may be used.

The first and second impurity atoms may be donors. For example, if the semiconductor region is silicon or germanium, the first atom and/or the second atom may be phosphorous (P), arsenic (As), antimony (Sb) or bismuth (Bi).

The first and second impurity atoms may comprise acceptors. For example, if the semiconductor region is silicon or germanium, the first atom and/or the second atom may be boron (B), aluminium (Al) or gallium (Ga).

The crystalline semiconductor region may extend between the source and drain regions. The crystalline region may be a crystalline semiconductor substrate, a layer of crystalline semiconductor material which is deposited or grown or a layer structure comprising two or more layers, of which, one may be a substrate. The crystalline semiconductor layer may be monocrystalline. The source and drain regions may comprise a two-dimensional electron gas or a two-dimensional hole gas.

The source and drain regions may be first and second doped regions of semiconductor. The impurity molecule may be buried below a principal surface of a semiconductor layer (which may be a substrate) and the first and second doped regions may be buried below the principal surface. The impurity molecule and the source and drain regions are preferably co-planar, i.e. lying in the same plane.

Thus, the impurity molecule and the contact regions may be formed by ion implantation which can help to position the impurity molecule or by STM lithography.

The device may include a set of registration marks which are used during fabrication to align the impurity molecule, contact regions and other elements of the device, such as one or more gates.

The device may comprise a first tunnel barrier region interposed between the source region and diatomic impurity molecule and a second tunnel barrier region disposed between the diatomic impurity molecule and drain region. A tunnel barrier region may comprise a dielectric region. A tunnel barrier region may comprise a depleted semiconductor region.

The source and drain region may be separated by no more than 60 nm, no more than 50 nm, no more than 40 nm, no more than 30 nm or no more than 20 nm. Thus, a tunnel barrier can have thickness of up to 30 nm. The diatomic impurity molecule may be equidistant or substantially equidistant (e.g. within 10 %) from the source and drain regions.

The single-molecule conduction device may be a transistor comprising at least one gate electrode. The at least one gate electrode may include a gate electrode which is a top electrode, a bottom electrode or a side electrode.

The gate electrode may comprise a doped region of semiconductor. The gate electrode may comprise a region of metal (such as aluminium or gold) or metal alloy.

The gate electrode and the diatomic impurity molecule may be separated by a gate dielectric region. The gate electrode and the diatomic impurity molecule may be separated by a depleted semiconductor region. The gate electrode and the diatomic impurity molecule may be separated by at least 2 nm, at least 5 nm, at least 10 nm or at least 20 nm. The gate electrode and the diatomic impurity molecule may be separated by no more than 100 nm or no more than 50 nm.

According to a second aspect of the present invention there is provided a circuit, optionally a complementary metal oxide semiconductor (CMOS) circuit comprising at least one device according to any preceding claim coupled to one or more other devices.

The circuit may be a logic circuit. The circuit may be memory.

The semiconductor may be silicon or germanium and the impurity molecule may comprise a dimer of donors, such as phosphorous (P), arsenic (As), antimony (Sb) or bismuth (Bi) or a dimer of acceptors, such as boron (B), aluminium (Al) or gallium (Ga). The inter-atomic distance, r, may be no more than 5 nm. The method may further comprise applying a magnetic field. The magnetic field may be static. The magnetic field may be selectably applied, for example, by virtue of a current passing through a wire. Applying a magnetic field can be used for filtering the spin of a charge carrier passing through the device.

The method may further comprise applying a bias to a gate so as to control transport of charge carriers through the device.

Certain embodiments of the present invention will now be described, by way of example, with reference to the accompanying drawings in which:
Figure 1 schematically illustrates a single-charge tunnelling transistor comprising an island in the form of a diatomic impurity molecule;
Figure 2 shows a potential profile for a diatomic impurity molecule;
Figure 3 illustrates dimensions of the transistor shown in Figure 1;
Figure 4 is a schematic circuit diagram for measuring and controlling the transistor shown in Figure 1;
Figure 5 is a plan view of a first single-charge tunnelling transistor;
Figure 6 is a cross-sectional view of the transistor shown in Figure 5 taken along the line A - A';
Figure 7 is a plan view of second single-charge tunnelling transistor;
Figure 8 is a cross-sectional view of the transistor shown in Figure 5 taken along the line B - B';
Figure 9 is a plan view of third single-charge tunnelling transistor
Figure 10 is a cross-sectional view of the transistor shown in Figure 8 taken along the line C - C';
Figure 11 is a potential profile for a diatomic impurity molecule;
Figure 12 is a measured radio-frequency reflectometry transfer curve for the device shown in Figure 9;
Figure 13 is a measured stability diagram for the device shown in Figure 9 showing a D₂²⁺-D₂⁺ transition;
Figure 14 is a measured stability diagram for the device shown in Figure 9 showing a D₂⁺-D₂° transition;
Figure 15a is a plot of the first ionization energy of a donor molecule as a function of the inter-donor distance R;
Figure 15b is a plot of second ionization energy of a donor molecule as a function of the inter-donor distance R;
Figure 15c is a plot of charging energy of a donor molecule as a function of the inter-donor distance R; and
Figure 15d is a plot of singlet-triplet splitting of a donor molecule as a function of the inter-donor distance R.

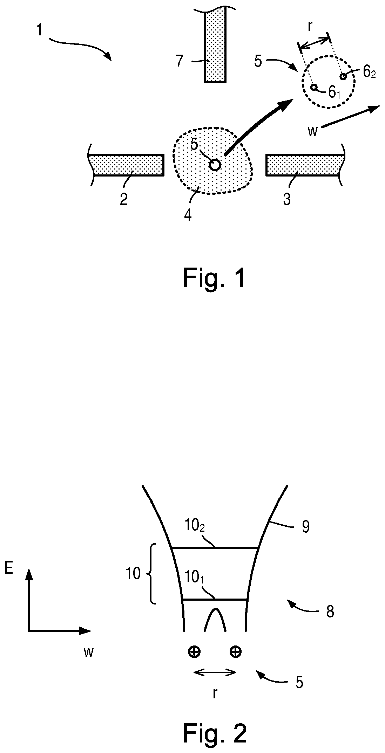

Figure 1 illustrates a single-charge tunnelling device 1 in the form of a single-charge tunnelling transistor 1.

Referring to Figure 1, the single-charge tunnelling transistor 1 (hereinafter simply referred to as a "transistor") comprises first and second contact regions 2, 3 (herein also referred to as "source and drain regions") and a semiconductor region 4 interposed between the first and second contact regions 2, 3. The semiconductor region 4 preferably comprises silicon. The transistor 1 comprises a diatomic impurity molecule 5 consisting of first and second impurity atoms 61, 62 disposed in the semiconductor region 4. The impurity atoms 61, 62 are strongly coupled through strong electrostatic coupling. The impurity molecule 5 provides an isolated island through which charge carriers, for example electrons, can tunnel when passing from one contact region 2 to the another contact region 3. Thus, the single-charge tunnelling transistor 1 may also be referred to as single-molecule transistor. The transistor 1 may comprise more than one island 5. For example, a chain of diatomic impurity molecules 5 may be interposed between the contact regions 2, 3.

Taking an example in which the semiconductor region 4 is formed of silicon, the diatomic impurity molecule 5 may consist of atoms of phosphorous (P), arsenic (As) or other donors to form an n-type device or atoms of boron (B) or other acceptors to form a p-type device.

Referring still to Figure 1, charge-carrier transport can be controlled by a gate electrode 7 which is spaced apart from impurity molecule 5. As will be explained in more detail later, a region of dielectric material or a depletion region may be interposed between the impurity molecule 5 and the gate electrode 7.

The first and second atoms 61, 62 have a (centre-to-centre) inter-atomic distance, r, no more than 10 nm. The inter-atomic distance, r, may be no more than 5 nm, no more than 2 nm or no more than twice the lattice constant of the semiconductor.

Figure 2 schematically illustrates a potential energy profile 8 of the diatomic impurity molecule 5.

Referring to Figure 2, the impurity molecule 5 forms a double well potential 9. The double well potential 9 contains at least one bound, hybridised state 10, i.e. a state which extends across the molecule 5. The double well potential 9 may contain first and second bound, hybridised states 101, 102.

Reducing the inter-atomic distance, r, to or below 10 nm can help to increase charge carrier confinement compared to a corresponding device employing a single atom as an island thereby increasing the ionization energy and the charging energy of the device. This can help to raise a minimum temperature of operation of a device.

Reducing the inter-atomic distance, r, to or below 5 nm can also help to increase spin filtering. The second state 102 is the second bound state of the molecule 5. This is the doubly-occupied state of the molecule, for example, As2 or other molecule of donor atoms or acceptor atoms. In this situation the spin singlet (i.e. spins of the two states are in opposite directions) is lower in energy than the spin triplet (spins of the two states are in the same direction) due to exchange coupling. The degree of splitting is substantial for inter-donor separations of 5 nm or less. In that case, the splitting is larger than the thermal energy at liquid helium temperatures and could be as large as 60 meV corresponding to a thermal energy of 100 K.

By applying suitable biases so that transport takes please through the spin singlet, then the spin of the electron that tunnels through the device will be opposite to the spin of the electron that is already bound creating a filter for the electron spin. In order to define the spin direction of the bound electron, a small magnetic field (around 1 mT) can be applied. Consequently, the spin of the transiting electron will be of opposite direction to that already bound.

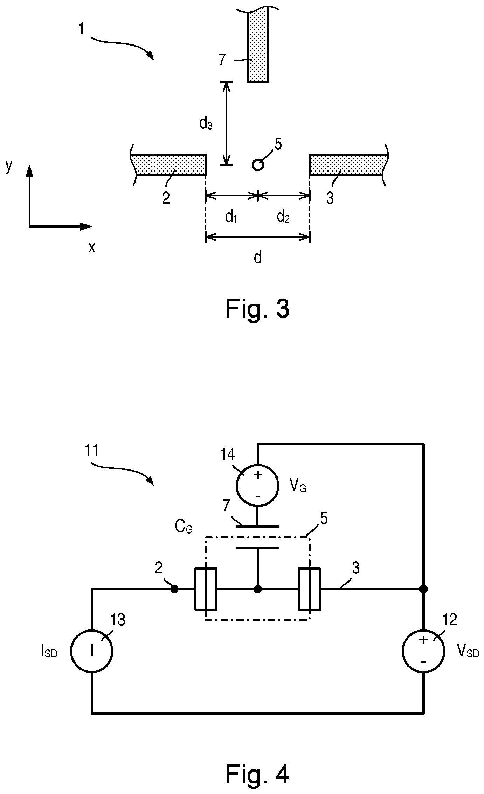

Figure 3 illustrates dimensions of the transistor 1.

Referring to Figure 3, the contact regions 2, 3 are separated by a distance, d. The impurity molecule 5 is preferably disposed midway between the contact regions 2, 3. Thus, the source region 2 and the impurity molecule 5 are separated by a distance, *d*₁, and the drain region 3 and the impurity molecule 5 are separated by a distance, *d*₂, where *d*₁ = d₂ = 0.5 *d*. The distance, *d*, may be no more than 20 nm, no more than 30 nm, no more than 40 nm, no more than 50 nm or no more than 60 nm.

Figure 4 illustrates a basic circuit 11 for controlling and measuring the transistor.

Referring to Figure 4, the circuit 11 includes a first voltage source 12 and a current meter 13 arranged in series between the source and drain regions 2, 3. A second voltage source 14 is arranged between the gate electrode 7 and the drain region 3.

The first voltage source 12 is used to apply a bias, *Vs_{D},* between the source and drain regions 2, 3 and the current meter 13 measures the current, *I_{D},* through the device (usually referred to as the "drain current"). The second voltage source 14 is used to apply a bias, *V_{G},* to the gate electrode 7 and, thus, induce a charge, *Q_{G}*, on the impurity molecule 5, where *QG* = *C_{G}V_{G}* and *C_{G}* is the gate capacitance.

The transistor may include additional gate electrodes and the circuit may have additional voltage sources.

The transistor can be implemented in different ways, as will now be described in more detail.

### Transistor 1₁

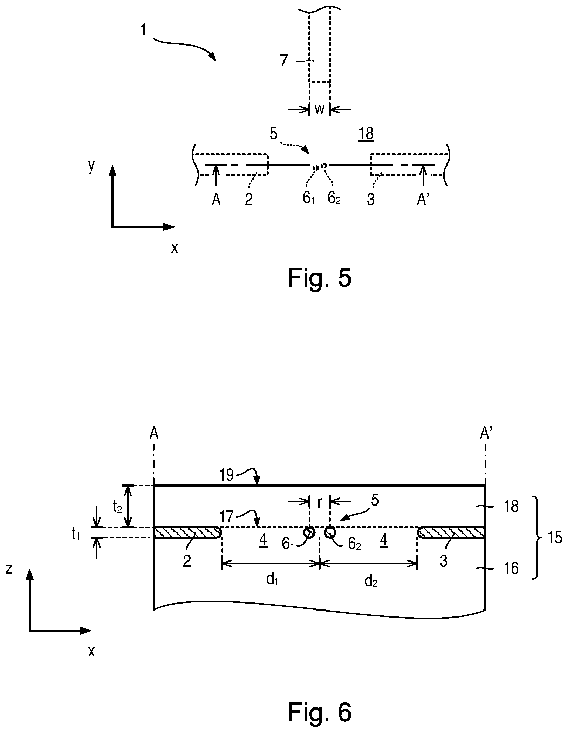

Referring to Figures 5 and 6, a first transistor 1₁ is shown.

The contact regions 2, 3 and gate 7 take the form of doped semiconductor regions embedded within a semiconductor layer structure 15 comprising a semiconductor substrate 16 having a principal surface 17 and an overlying semiconductor layer 18 having a principal surface 19. The semiconductor layer structure 15 is monocrystalline (or "single crystal"). The substrate 16 takes the form of a die of a semiconductor wafer. The contact regions 2, 3 and gate 7 are disposed at or just below the principal surface 17 of the substrate 16.

The contact regions 2, 3 and gate 7 have a thickness, *t₁.* The thickness, *t₁,* may be about 10 nm. The contact regions 2, 3 and gate 7 may have a width, w, proximate to the impurity molecule of about 10 nm. However, the dimensions and geometry of the source and drain regions 2, 3 and gate 7 may differ.

The contact regions 2, 3 and gate 7 may be connected to leads (not shown) running to other devices (not shown) or contact pads (not shown). The leads (not shown) may have greater cross-sectional area (i.e. which have a greater thickness and/or width) and/or higher conductivity. The leads may comprise metal or highly-doped semiconductor tracks.

The overlying semiconductor layer 18 has a thickness, *t₂.* The thickness, *t₂,* may be about 20 nm. The thickness, *t₂,* may be less than 20 nm or more than 20 nm.

The first and second atoms 61, 62 are also embedded within a semiconductor layer structure 15. The atoms 61, 62 are disposed at or just below the principal surface 17 of the substrate 16.

The semiconductor substrate 16 takes the form of a silicon wafer. The silicon substrate 16 preferably has a (100) crystallographic orientation. However, other orientations can be used. The silicon substrate preferably has a high resistivity, i.e. ρ > 7000 Ωcm.

The semiconductor layer 18 takes the form of an epitaxially-grown silicon layer. The contact regions 2, 3 and gate 7 and comprise phosphorous-doped silicon. The first and second atoms 6₁, 6₂ are phosphorous atoms.

The transistor 1₁ can be fabricated using a process described in WO 2009/097643 A1.

The impurity molecule 5 is deterministically positioned with respect to the contact regions 2, 3 and gate 7.

The fabrication process involves using hydrogen-resist lithography using a scanning tunnelling microscope to control the dissociation of a dopant precursor, in this case phosphine (PH₃), before incorporating two phosphorous atoms 6₁, 6₂ at the required position in the silicon substrate 16. The phosphorus atoms 6₁, 6₂ can be placed with a lateral accuracy of ±1 lattice sites, which in the case of silicon is ±0.38 nm.

The contact regions 2, 3 and gate 7 are formed in the same way at the same stage. Thus, the positions of the phosphorus atoms 61, 62 with respect to each other and with respect to the contact regions 2, 3 and gate 7 can be accurately controlled.

After successful incorporation of the impurities, the silicon layer 18 is overgrown in order to provide termination. This is performed at a low temperature, for example 350 °C, to help ensure that the dopant does not diffuse during growth and remain at the selected lattice sites.

### Transistor 1₂

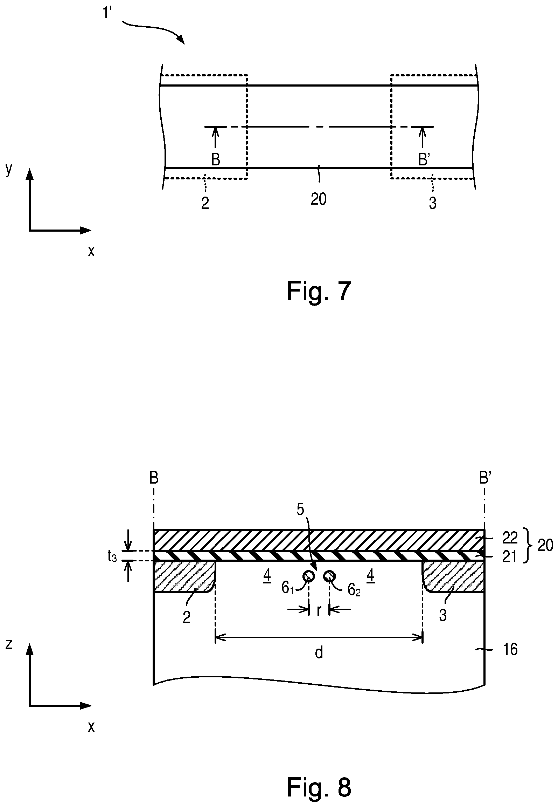

Referring to Figures 7 and 8, a second transistor i2 is shown.

The second transistor 1₂ is similar to the first transistor 1₁. The second transistor 1₂ differs mainly from the first transistor 1₁ in the manner in which the impurity molecule 5 is positioned with respect to the contact regions 2, 3.

The second transistor 1₂ also differs from the first transistor 1₁ in that the gate 7 is omitted (although it can be retained) and a top gate structure 20 is added (although it can be omitted). The top gate structure 20 comprises a gate dielectric 21 in the form of a layer of silicon dioxide (SiO₂) overlying the silicon substrate 16 and a gate electrode 22 in the form of layer of metal (such as aluminium) or highly-doped semiconductor, preferably silicon. The gate dielectric 20 has a thickness appropriate to the dielectric constant and breakdown field of the dielectric material. In this case, the gate dielectric

21 comprises a layer of silicon dioxide having a thickness, *t*₃, of 10 nm. The gate electrode 22 can be used in the same way as the (in-plane) gate electrode 7 (Figure 5).

In the second transistor 1₂, the impurity molecule 5 is non-deterministically positioned with respect to the contact regions 2, 3. For example, the second transistor i2 may be one of many notionally identical transistors formed on the same substrate. One or more (but not necessarily all) of the transistors have an impurity molecule located in a suitable position. Transistors which has an impurity molecule located in a suitable position can be found by measuring the current-voltage characteristics of the transistors and determining whether the device has or exceeds a minimum turn-on current threshold.

In this fabrication process, dopants, in this case phosphorous, are incorporated globally in the silicon substrate 16 by means of a low-dose (for example, D = 10¹¹ cm⁻²) ion implantation through a 10 nm-thick sacrificial silicon oxide layer (not shown) at an energy of, for example, 15 keV. Preferably, molecular ions (such as P₂⁺, As₂⁺, Sb₂⁺ or B₂⁻) are used to aid formation of the impurity molecule 5 in the active region 4 of the device. However, atomic ions (such as P+, As⁺, *etc.)* can be used.

Ion implantation restricts the location and separation of the two atoms 61, 62 to 10 nm or less due to straggle (i.e. standard deviation).

The contact regions 2, 3 and, optionally, the gate 7 are defined by a resist mask patterned using electron-beam or optical lithography and formed by ion implantation at a high dose (for example, D = 10¹⁵ cm⁻²) at an energy of, for example, 15 keV. The same species as the impurity molecule can be used, although atomic ions may be used. The sacrificial silicon oxide (not shown) can then be removed. A 10 nm-thick gate oxide 21 is be grown, for example, at 850 °C. Growth at an elevated temperature can help to anneal out implantation damage. An anneal in a forming gas (not shown) at 450 °C is performed for 30 minutes, followed by a rapid thermal anneal, at 1050 °C for 15 seconds, to reduce the number of interface traps and the density of fixed oxide charge. A series of thermal processing steps can help to promote diffusion of the low-dose dopant species towards the interface due to the large segregation coefficient of group V elements at silicon-silicon dioxide interfaces thereby favouring the formation of molecular centres. The contacts 2, 3 are separated by a distance, *d.* In this case, *d* is about 40 nm. The region between the contacts 2, 3 is gated by the gate electrode 20 making use of the field effect.

As explained earlier, multiple transistors i2 are fabricated in parallel on the same substrate 16. Transistors 1' with impurity molecules 5 located equidistantly from the contact regions 2, 3 (i.e. at distance d/2) yield give the highest on-current.

### Transistor 1₃

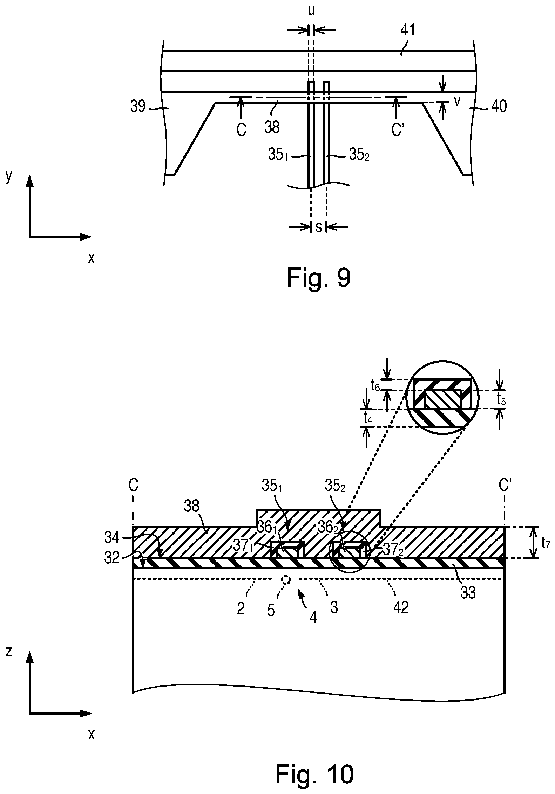

Referring to Figures 9 and 10, a third transistor 1₃ is shown. The third transistor 1₃ takes the form of a double-gated metal-oxide-semiconductor field effect transistor (MOSFET).

The third transistor 1₃ includes a semiconductor substrate 31 having a principal surface 32, a dielectric layer 33 overlying the semiconductor substrate 32, having a principal surface 34 and providing a gate dielectric, and first and second top gate electrode structure 35₁, 35₂ disposed on the dielectric layer 33 comprising respective electrodes 36₁, 36₂ (hereinafter referred to as "tunnel barrier gate electrodes" or simply "tunnel barrier gates") and respective surface dielectric layers 37₁, 37₂. The tunnel barrier gate electrodes 36₁, 36₂ are generally finger-like, spaced apart along a first direction (in this case x-direction) and orientated along a second, orthogonal direction (in this case the y-direction).

The third transistor 1₃ includes a third top gate electrode 38 (hereinafter referred to the "top gate electrode" or simply "top gate") which is disposed mainly on the dielectric layer 33. The top gate 38 generally takes the form of a stripe having flared ends 39, 40 and runs along the first direction over the first and second tunnel barrier electrode structures 35₁, 35₂.

The third transistor 1₃ includes a side gate electrode 41 38 (hereinafter referred to simply as the "side gate") running along the first direction. However, the side gate 41 may be omitted.

The tunnel barrier gates 36₁, 36₂ are separated by a distance, s, about 100 nm. Each tunnel barrier gate 36₁, 36₂ has a width, u, of about 40 nm. The top electrode 38 has a width, v, of about 120 nm. Values of s, u and v may differ.

The substrate 31 comprises a high-resistivity (p > 7,000 Ωcm) (100) p-type silicon implanted with arsenic ions at a low dose (15 keV, 10¹¹ cm⁻²). The gate dielectric comprises silicon dioxide (SiO2) and has a thickness, *t*₄, of 10 nm. The gate dielectric may comprise a different dielectric material, such as a silicon nitride or a high-k dielectric material. The thickness, *t₄*, can take other values which provide suitable gate isolation appropriate to the dielectric constant and breakdown field of the dielectric material.

The tunnel barrier gates 36₁, 36₂ comprise aluminium (Al) having a thickness, *t₅,* of 25 nm. The surface dielectric layers 37₁, 37₂ comprise aluminium oxide (Al₂O₃) formed by natural oxidation of aluminium and have a thickness, *t₆*, of a few nanometres. The tunnel barrier gates 36₁, 36₂ may comprise a different material, such as gold (Al). A thin adhesion-promoting layer may be used. The surface dielectric layers 37₁, 37₂ need not be formed by natural oxidation of the tunnel barrier gate material. The dielectric material (which may be an oxide) may be deposited, for example, by sputtering.

The top gate 38 takes the form of a layer of aluminium (Al) having a thickness, *t₇*, of 100 nm. The top gate 38 may comprise a different material, such as gold (Au), and may have a different thickness. A thin adhesion-promoting layer may be used.

The tunnel barrier gate electrodes 36₁, 36₂, 38, 41 are defined by a resist mask patterned using electron-beam lithography and thermal evaporation.

The top electrode 38 is used to induce an electron accumulation layer 42 (also referred to as a "two-dimensional electron gas") in the underlying semiconductor substrate 31. The first electrode structure 361 can be used to deplete the two-dimensional electron gas 42 and so form source and drain regions 2, 3.

Ohmic contacts (not shown) to the electron accumulation layer 42 are formed by implantation of arsenic ions at a high dose (15 keV, 10¹⁵ cm⁻²) and metal contacts.

An impurity ion 5 is disposed under the first tunnel barrier electrode 36₁. In this example, the impurity ion 5 is in a suitable location by chance. This can be achieved by fabricating a suitably large number of devices.

The impurity ion profile is calculated by an implantation Monte-Carlo simulator and has a maximum at 10 nm from the surface 32 and a peak density of 5×10¹⁶cm⁻³ resulting in a statistical mean inter-dopant distance of 27 nm. However, segregation of arsenic towards the surface 32 during the subsequent thermal processing is expected and is thought to lead to an increase in the donor density at the interface and favours clustering. By comparison, the background phosphorus doping of the substrate 31 is estimated to be lower than 10¹² cm⁻².

The tunnel barrier gates 36₁, 36₂ allow independent study of sub-threshold phenomena in the region beneath the single barrier.

Electrical transport measurements are performed at a base temperature (in this case, 200 mK) of a dilution refrigerator (not shown) using radio-frequency reflectometry.

Radio-frequency reflectometry is performed at 360 MHz by embedding the transistor 1₃ in an rf-tank circuit (not shown) formed by a surface mount inductor having a value of 390 nH and a paracitic capacitance to ground of 500 fF.

This technique (i.e. radio-frequency reflectometry) probes differential conductance of the device generating a proportional DC output voltage *V_{IF}.* Electrical transport measurements need not involve radio-frequency reflectometry. Instead, a circuit similar to the circuit 11 shown in Figure 4 having two additional voltage sources so that there are three voltage sources for applying respective biases to the first tunnel barrier gate 36₁, second tunnel barrier gate electrode 36₂ and top gate 38 may be used.

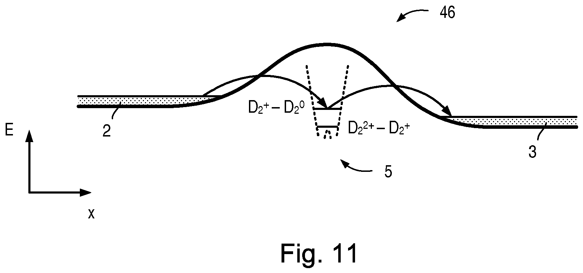

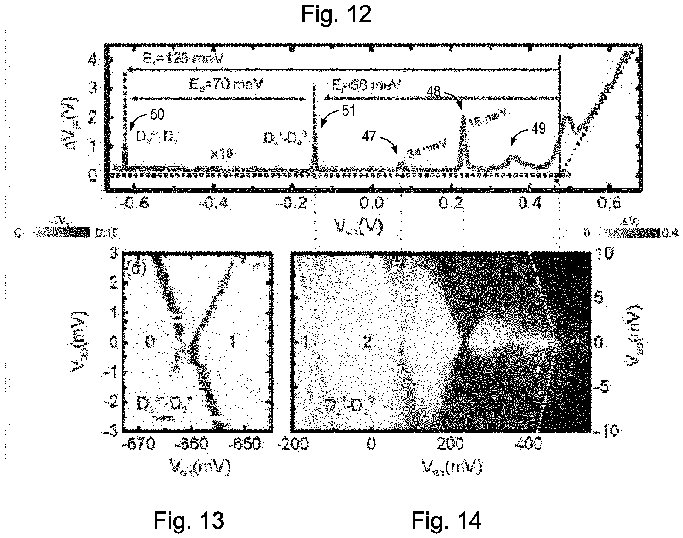

Figure 11 shows an energy band diagram 46 along transport direction of the device and Figure 12 shows the rf response as a function of a first tunnel barrier gate voltage *V_{G1}* when the top gate voltage *V_{TG}* and the second tunnel barrier gate voltage *V_{G1}* are set well-above threshold, namely *V_{TG}* = *V_{G2}* = 2 V.

The first tunnel barrier gate 36₁ controls locally the energy band bending and allows the electrochemical levels of the impurity 5 to be tuned, i.e. the energy required to add an extra electron to the molecule to be tuned. Whenever one of these levels lies within the energy window of the bias voltage, transport through the structure can occur and resonant peaks appear.

Below the conduction band edge, i.e. below *V_{G1}* = 440 mV, the plot exhibits first, second and third peaks 47, 48, 49. Due to their low energy with respect to the conduction band edge, these peaks 47, 48, 49 correspond to transport through single dopant or unintentional quantum dot states generated due to potential irregularities at the interface.

The device exhibits a fourth peak 50 (corresponding to D₂²⁺- D₂⁺) and fifth peak 51 (a corresponding to D₂⁺-D₂°). These resonant peaks correspond to as a first and a second electron being added to the donor molecule 45 due to its position deep below the conduction band edge and its large charging energy.

In order to quantify these energies, the rf-response was measured as a function of source barrier voltage and source-drain bias.

Referring to Figure 13, characteristic Coulomb diamonds are revealed. The charging energy of the system can be read from the *V_{SD}* axis at the point where the edges of the diamonds meet. This method provides an absolute reading of the energy and avoids the use of calibration parameters that dependent on the electron occupancy of the impurities as well as the variable electrostatic conditions. By extending the edges of the D₂²⁺-D₂⁺ and D₂⁺-D₂° transitions, the charging energy, *E*_{c} = 70±3 meV is found. Moreover, to obtain the first ionization energy, the point at which the D₂⁺-D₂° transition meets with the edge of the conduction band is calculated (indicated by the dotted white lines). A value of *E_{I}* = 56±5 meV is found. The second ionization energy is, therefore, *E_{II}* =126±6 meV.

These values are markedly larger than the bulk values for As:Si. In bulk, arsenic provides a charging energy of 52 meV and the first and second ionization energies are 2 meV and 54 meV respectively. These results represent enhancement by a factor of 2.3 of the second ionization energy. This allows an increase in the operation temperature of the device by a factor of 2.3.

The measured spectrum is in excellent agreement with a theoretical model based on a modified effective mass approximation when arsenic dopants pair up in a molecule with an inter-atomic distance of R= 2.5±0.5 nm. These measurements gather the first combined theoretical and experimental evidence of detection of a strongly interacting donor pair in silicon.

### Modelling of the transistor 1₃

Calculations are performed within an improved effective mass approach which includes central cell corrections with an empirical rcc to obtain correct A₁ energies, the full valley structure of the Si conduction band and electron-electron correlations through a configuration interaction method. The theoretical approach allow exploration of the full range of possible distance values between substitutional dopants for one and two-electron states (except for immediately vicinal pairs in which the central cell of the two donors might overlap). An exponential envelope wave-function exp(-*r*/*aᵢ**) is adopted, where *aᵢ** can be different for each state. Mass anisotropy is neglected for simplicity. The effective wavefunction radii are calculated variationally as a function of the distance *R* between the dopants.

Unlike molecules in vacuum, where the distance between the constituent atoms is determined by the equilibrium between repulsive and attractive energies, molecules in a solid are characterized by a distance *R* given by the fixed positions of the atoms in the lattice. The finite phase velocity along the Cartesian directions introduces an energy dependence on the orientation of the molecule in the crystal, more evident when R is of the order of the wavefunction radius. Another consequence of the multiple minima in the conduction band is the oscillatory radii versus R plots. Equivalent oscillations have been found before in the exchange coupling between donors. The oscillation periodicity is not commensurate with the lattice. This incommensurability is responsible for the apparently noisy energy curves, mainly in the <110> and <111> directions.

A naive comparison of the experimental values with the theory of H2 molecules leads to disappointing results even if the rescaling of the energies and distances is taken into account. The largest possible value for the charging energy of the hydrogen molecule occurs at the unphysical limit of R → O where the two atoms are merged into a single He-like atom and *Ec* = 2.2*Ry**= 68meV, which is still not large enough to explain the present measurements. The same problem appears for the measured first and second ionization energies, which are larger than the theoretical upper bounds for H2 of 56 meV and 125 meV respectively.

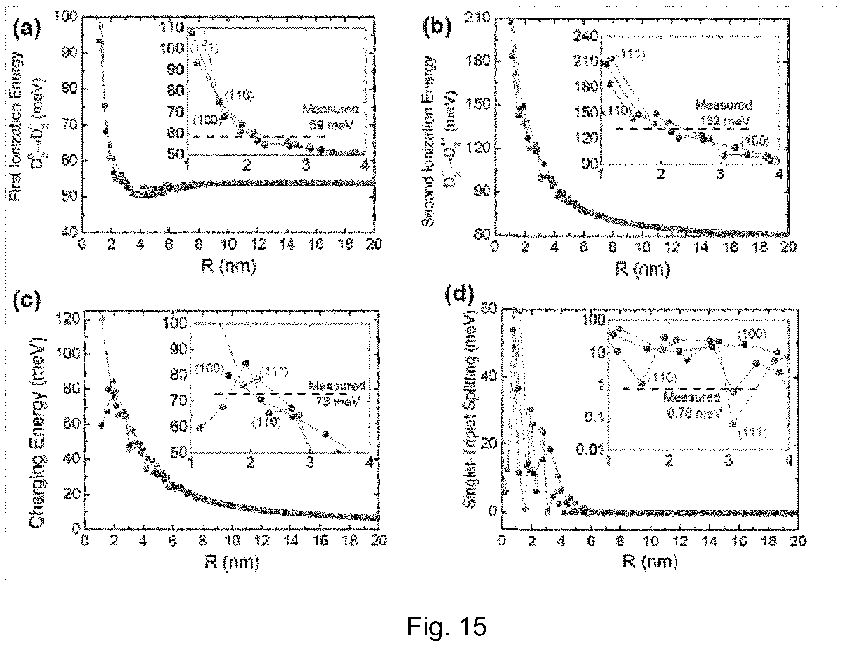

Figures 15 a to 15d illustrate characterization of donor molecules as a function of the inter-donor distance R. Insets show a zoom-in for the smallest values of R and comparison with the measured values

Referring to Figures 15c, the central cell correction is indirectly responsible for the enhancement of the electron- electron repulsion and consequently large Ec shown in Figure 15a due to tighter confinement of the A₁ states.

Referring to Figures 15a and 15b respectively, the same core correction leads to smaller atomic onsite energies, enhancing the one-electron binding energy (Figure 15a) and two-electron binding (Figure 15b). Both the binding energy and the electron-electron repulsion energy have large classical components, so that the quantum interference of the valley states does not play a major role and these quantities are fairly monotonic (especially the binding energies).

It will be appreciated that many modifications may be made to the embodiments hereinbefore described.

The first and second atoms need not be the same. For example, different dopants can be used.

The single-charge tunnelling device need not be a transistor. The device may be a two-terminal device. The device may be a three-terminal device or device with more than three terminals which is normally operated as a two-terminal device, i.e. one or more gates is (are) used to tune device. The single-charge tunnelling device may be a more complex device, such as single-charge turnstile or single-charge pump.

The device may form part of a larger device, such as multi-transistor logic gate or memory cell.

The device may comprise more than one impurity molecule. For example, the device may comprise a series of two or more impurity molecules.

## Claims

1. A single-charge tunnelling device comprising:
source and drain regions (2, 3);
a semiconductor region (4) between the source and drain regions; and
an island in the form of a diatomic impurity molecule (5) comprising first and second impurity atoms (61, 62) disposed in the semiconductor region;
**characterised in that** the first and second atoms have an inter-atomic distance, r, no more than 10 nm.

2. A device according to claim 1, wherein the first and second impurity atoms comprise donors.

3. A device according to claim 1 or 2, wherein the first atom comprises phosphorus (P), arsenic (As), antimony (Sb) or bismuth (Bi).

4. A device according to any preceding claim, wherein the second atom comprises phosphorus (P), arsenic (As), antimony (Sb) or bismuth (Bi).

5. A device according to any preceding claim, wherein the first and second atoms are the same element.

6. A device according to any preceding claim, wherein the semiconductor region (4) extends between the source and drain regions (2, 3).

7. A device according to any one of claims 1 to 6, wherein the source and drain regions (2, 3) comprise a two-dimensional electron gas (42) or a two-dimensional hole gas.

8. A device according to any one of claims 1 to 6, wherein the source and drain regions (2, 3) comprise first and second doped regions respectively.

9. A device according to claim 8, wherein the impurity molecule (5) is buried below a principal surface of a semiconductor layer and the first and second doped regions are buried below the principle surface.

10. A device according to any preceding claim, comprising a first tunnel barrier region interposed between the source region (2) and the diatomic impurity molecule (5) and a second tunnel barrier region interposed between the diatomic impurity molecule and the drain region (3).

11. A device according to claim 10, wherein the first and second tunnel barrier regions comprise respective first and second dielectric regions.

12. A device according to claim 10 or 11, wherein the first and second tunnel barrier regions comprise respective first and second depleted semiconductor regions.

13. A device according to any preceding claim, wherein the source and drain region are separated by no more than 60 nm, no more than 50 nm, no more than 40 nm, no more than 30 nm or no more than 20 nm.

14. A device according to any preceding claim, comprising:
at least one gate electrode (7; 361).

15. A circuit, optionally a CMOS circuit, comprising at least one device according to any preceding claim.

## Patentansprüche

1. Einzelladungstunnelvorrichtung, umfassend:
Source- und Drain-Bereiche (2, 3);
einen Halbleiterbereich (4) zwischen den Source- und Drain-Bereichen; und
eine Insel in Form eines zweiatomigen Fremdmoleküls (5), das erste und zweite Fremdatome (6₁, 6₂) umfasst, die sich in dem Halbleiterbereich befinden;
**dadurch gekennzeichnet, dass** die ersten und zweiten Atome einen Interatomabstand, *r*, von nicht mehr als 10 nm aufweisen.

2. Vorrichtung nach Anspruch 1, wobei die ersten und zweiten Fremdatome Donoren umfassen.

3. Vorrichtung nach Anspruch 1 oder 2, wobei das erste Atom Phosphor (P), Arsen (As), Antimon (Sb) oder Bismut (Bi) umfasst.

4. Vorrichtung nach einem der vorstehenden Ansprüche, wobei das zweite Atom Phosphor (P), Arsen (As), Antimon (Sb) oder Bismut (Bi) umfasst.

5. Vorrichtung nach einem der vorstehenden Ansprüche, wobei das erste und das zweite Atom das gleiche Element sind.

6. Vorrichtung nach einem der vorstehenden Ansprüche, wobei sich der Halbleiterbereich (4) zwischen den Source- und Drain-Bereichen (2, 3) erstreckt.

7. Vorrichtung nach einem der Ansprüche 1 bis 6, wobei die Source- und Drain-Bereiche (2, 3) ein zweidimensionales Elektronengas (42) oder ein zweidimensionales Lochgas umfassen.

8. Vorrichtung nach einem der Ansprüche 1 bis 6, wobei die Source- und Drain-Bereiche (2, 3) entsprechende erste und zweite dotierte Bereiche umfassen.

9. Vorrichtung nach Anspruch 8, wobei das Fremdmolekül (5) unter einer Hauptoberfläche einer Halbleiterschicht vergraben ist, und wobei der erste und der zweite dotierte Bereich unter der Hauptoberfläche vergraben sind.

10. Vorrichtung nach einem der vorstehenden Ansprüche, die einen ersten Tunnelbarrierenbereich umfasst, der sich zwischen dem Source-Bereich (2) und dem zweiatomigen Fremdmolekül (5) befindet, und mit einem zweiten Tunnelbarrierenbereich, der sich zwischen dem zweiatomigen Fremdmolekül und dem Drain-Bereich (3) befindet.

11. Vorrichtung nach Anspruch 10, wobei der erste und der zweite Tunnelbarrierenbereich entsprechende erste und zweite dielektrische Bereiche umfassen.

12. Vorrichtung nach Anspruch 10 oder 11, wobei der erste und der zweite Tunnelbarrierenbereich entsprechende erste und zweite Verarmungshalbleiterbereiche umfassen.

13. Vorrichtung nach einem der vorstehenden Ansprüche, wobei der Source- und Drain-Bereich einen Abstand von nicht mehr als 60 nm, von nicht mehr als 50 nm, von nicht mehr als 40 nm, von nicht mehr als 30 nm oder von nicht mehr als 20 nm aufweisen.

14. Vorrichtung nach einem der vorstehenden Ansprüche, umfassend:
mindestens eine Gate-Elektrode (7; 36₁).

15. Schaltung, optional eine CMOS-Schaltung, die mindestens eine Vorrichtung nach einem der vorstehenden Ansprüche umfasst.

## Revendications

1. Dispositif à effet tunnel à charge unique comprenant :
des régions de source et de drain (2, 3) ;
une région semi-conductrice (4) entre les régions de source et de drain ; et
un îlot sous la forme d'une molécule d'impureté diatomique (5) comprenant des premier et second atomes d'impureté (6₁, 6₂) disposés dans la région semi-conductrice ;
**caractérisé en ce que** les premier et second atomes ont une distance inter-atomique, r, non supérieure à 10 nm.

2. Dispositif selon la revendication 1, les premier et second atomes d'impureté comprenant des donneurs.

3. Dispositif selon la revendication 1 ou 2, le premier atome comprenant le phosphore (P), l'arsenic (As), l'antimoine (Sb) ou le bismuth (Bi).

4. Dispositif selon l'une quelconque des revendications précédentes, le second atome comprenant le phosphore (P), l'arsenic (As), l'antimoine (Sb) ou le bismuth (Bi).

5. Dispositif selon l'une quelconque des revendications précédentes, les premier et second atomes étant le même élément.

6. Dispositif selon l'une quelconque des revendications précédentes, la région semi-conductrice (4) s'étendant entre les régions de source et de drain (2, 3).

7. Dispositif selon l'une quelconque des revendications 1 à 6, les régions de source et de drain (2, 3) comprenant un gaz d'électrons bidimensionnel (42) ou un gaz de trous bidimensionnel.

8. Dispositif selon l'une quelconque des revendications 1 à 6, les régions de source et de drain (2, 3) comprenant respectivement des première et seconde régions dopées.

9. Dispositif selon la revendication 8, la molécule d'impureté (5) étant enterrée sous une surface principale d'une couche semi-conductrice et les première et seconde régions dopées étant enterrées sous la surface principale.

10. Dispositif selon l'une quelconque des revendications précédentes, comprenant une première région de barrière à effet tunnel interposée entre la région de source (2) et la molécule d'impureté diatomique (5) et une seconde région de barrière à effet tunnel interposée entre la molécule d'impureté diatomique et la région de drain (3).

11. Dispositif selon la revendication 10, les première et seconde régions de barrière à effet tunnel comprenant des première et seconde régions diélectriques respectives.

12. Dispositif selon la revendication 10 ou 11, les première et seconde régions de barrière à effet tunnel comprenant des première et seconde régions semi-conductrices appauvries respectives.

13. Dispositif selon l'une quelconque des revendications précédentes, les régions de source et de drain étant séparées par pas plus de 60 nm, pas plus de 50 nm, pas plus de 40 nm, pas plus de 30 nm ou pas plus de 20 nm.

14. Dispositif selon l'une quelconque des revendications précédentes, comprenant : au moins une électrode grille (7 ; 36₁).

15. Circuit, éventuellement un circuit CMOS, comprenant au moins un dispositif selon l'une quelconque des revendications précédentes.
